# EUROPEAN PATENT APPLICATION

(11) **EP 0 545 608 A2**
(43) Date of publication of application: **09.06.1993**
(21) Application number: 92310749.4
(22) Date of filing: 25.11.1992
(51) Int. Cl.: H01L 39/02

(54) **Superconducting joint for oxide superconductor tape**

(30) Priority: 02.12.1991 US 801158
(71) Applicant: GENERAL ELECTRIC COMPANY, Schenectady, NY 12345 (US)
(72) Inventor: Arendt, Ronald Henry, Schenectady, New York 12309 (US); Lay, Kenneth Wilbur, Schenectady, New York 12309 (US); Tkaczyk, John Eric, Delanson, New York 12053 (US)
(74) Representative: Pratt, Richard Wilson

(57) **Abstract**

A joint between tapes having a core of an oxide superconductor precursor in a silver sheath is formed by a method comprising, removing a section of the sheath from the tapes to form an exposed core surface on each tape. The tapes are positioned to overlap the exposed core surfaces, and pressed to compact the cores and bond the sheaths to seal the compacted cores therebetween. The pressed tapes are heated to form the oxide superconductor. A superconducting joint between the tapes comprises, a joint core comprised of the oxide superconductor and having a first width section extending between the tape cores to form a continuous superconducting path between the tapes, and at least one pair of second width sections each second width section extending from one of the tape cores and contiguous with the first width section to provide a continuous superconducting path from each tape core to the first width section, and a silver sheath extending over the first and second width sections to seal the joint core therein and separate the second width sections.

## Description

### Background of the Invention

This invention was made with Government support under Contract No. N00014-88-C-0681 awarded by the Department of the Navy, and contract DEAC05-84-0R21400 awarded by the Department of energy. The Government has certain rights in the invention.

This invention relates to superconducting joints, and a method of forming the superconducting Joints between tapes of high temperature oxide superconductor.

A new superconductor comprised of oxides of lanthanum, barium, and copper, and having a critical temperature of 30 Kelvin, K, was discovered at the Zurich laboratory of International Business Machines Corporation, J.G. Bednorz et al., "Possible High-T_{c} Superconductivity in the Ba-La-Cu-O System," Z. Phys. V. 64, 189 1987. The discovery of the lanthanum-barium-copper-oxide system led to the discovery of a series of superconducting systems having a high critical temperature above 30 K. Exemplary of the newly discovered systems are, lanthanum-strontium-copper-oxide, yttrium-barium-copper-oxide, bismuth-strontium-calcium-copper-oxide, and thalium-barium-calcium-copper-oxide. The superconductors in the above systems, having a critical temperature above 30 K, are herein referred to as high temperature oxide superconductors or oxide superconductors. Additional information about the oxide superconductors and methods of forming powders or films thereof can be found, for example, in the following disclosures incorporated herein by reference, "Chemical Engineering and the Development of Hot Superconductors," R. Kumar, Chemical Engineering Progress, pp.17-27, April 1990, and "Chemistry of High-Temperature Superconductors," A.W. Sleight, Science, Vol. 242, pp.1519-1527, Dec. 1988.

The discovery of the oxide superconductors enables the development of superconducting equipment operating at temperatures up to liquid nitrogen cooling, about 77 K, instead of liquid helium cooling, about 4.2 K. Among the applications for such oxide superconductors are power transmission lines, rotating machinery, superconducting magnets, e.g. for, fusion generators, particle accelerators, levitated vehicles, magnetic separation, energy storage, and magnetic resonance imaging. These devices require the development of wire or tape of the oxide superconductors.

Owing to the brittleness and reactivity of oxide superconductors, it is advantageous to form metal-ceramic composites of the oxide superconductor on a metal substrate. The malleability of a metal cladding on oxide superconductor wires, tapes, and multifilaments compensates for the ceramics brittleness. Furthermore, the metal provides a good means of thermal dissipation, stabilizing the superconductor environment. The stabilizing effect is of fundamental importance for Type II superconductors, in which undesirably large local rises in temperature can develop through flux jumping in the mixed state. Flux jumping is a sudden, localized flux motion resulting in a local rise in temperature. Unfortunately, the Type II oxide superconductors, in particular, bismuth-lead-strontium-calcium-copper-oxide, react with nearly every metal with which they come into contact.

Silver has been found to be compatible with and non-poisoning to the superconducting systems yttrium-barium-copper-oxide, thallium-barium-calcium-copper-oxide, and bismuth-strontium-calcium-copper-oxide. It is also known that lead can be added to the bismuth system in order to stabilize the phase having a critical temperature of 110 K, comprised of bismuth, strontium, calcium, and copper oxides in the ratio of about 2:2:2:3, respectively. Such superconductor compositions and phases are sometimes herein shown by a formula, for example, Bi₂Sr₂Ca₂Cu₃O_{10+y}. The cation ratios given in such formulas usually indicate the ideal structure, and the exact oxygen content per molecular unit is nominal so that y varies within about a fraction of one. In addition, there may be substitution of cations on other sites, cation vacancies, or oxygen interstitials present so that the actual superconducting phase is not exactly that given by the ideal formula.

One of the most promising methods of forming oxide superconductors into long wires or tapes is the powder in tube drawing-rolling process, for example, see "Development of High-T_{c} Superconducting Wire with High Critical Current Density", T. Matsumoto, K. Aihara, M. Seido, Hitachi Review, Vol. 39, (1990), No. 1, pp. 55-62, incorporated herein by reference. Briefly described, in this method superconducting powder was put into a 300 millimeter long silver tube with a 6 millimeter diameter and 0.5 millimeter wall thickness. Superconducting powders from the yttrium-barium-copper-oxide, thalium-barium-calcium-copper-oxide, and thalium-barium/strontium-calcium-copper-oxide systems were used. The filled tube was drawn in 30 repetitions to a diameter of 2.8 millimeters. The drawn tubing was rolled into 6 millimeter wide tape 0.05 to 0.5 millimeters in thickness. For example, rolling was repeated about 100 times for a tape of 0.01 millimeter thickness. The tape was heat treated at 910°C for twenty hours to react and sinter the core to form a continuous superconductor.

One use for such superconductive tape is for the windings in superconducting magnets. For example, a magnetic resonance imaging device can use 6 superconducting magnets, with the windings in each magnet requiring a continuous length of superconducting tape of over a kilometer. Individual magnets in the device are connected together to provide a continuous superconducting path through all six magnets. As a result, a continuous length of superconducting tape of many kilometers would be required for the device. Continuous lengths of many kilometers of superconductive tape will be difficult to form, and it would be desirable to join many shorter lengths. In addition, it can be expected that some breakage and damage of the tapes will occur during tape winding operations, necessitating joints to repair such breakage or damage.

Superconducting magnets are often used in apparatus requiring a constant magnetic field from the magnet. To maintain the constant magnetic field the magnet must operate in the superconducting, or persistent mode. Current loss in the magnet from internal resistance causes drift or reduction of the magnetic field. As a result, a superconducting joint is desirable for making the necessary connections between superconducting tapes to prevent drift of the magnetic field. The current-carrying capacity and magnetic field behavior of the joints should at least approach the current-carrying capacity and magnetic field behavior of the superconducting tape, or the joints will become the limiting factor in the current-carrying capacity of the device.

Murayama et al. disclose screen printed thick films of bismuth family superconductors were hot pressed between magnesium oxide substrates to form a polycrystalline bismuth oxide superconductor by solid phase sintering, "Hot-pressing of Bi-Pb-Sr-Ca-Cu-O Superconducting Thick Film," Japanese Journal of Applied Physics, Vol. 29, No. 6, June 1990, pp. L875-L877. Muto et al. disclose diffusion bonding of bismuth system superconducting rods by hot pressing at various temperatures and pressures in air, "Diffusion Bonding of Bi-Pb-Sr-Ca-Cu-O High-T_{c} Superconductors," Japanese Journal of Applied Physics, Vol. 29, No. 8, August 1990, pp. L1432-L1434.

An object of this invention is to provide a superconducting joint between tapes of the oxide superconductors.

Another object of the invention is a method for forming superconducting joints between tapes of the oxide superconductors.

Another object of the invention is a method for forming superconducting Joints between tapes of the oxide superconductors where the joints have a high current-carrying capacity, approaching the current-carrying capacity of the superconducting tape.

### Brief Description of the Invention

A method for forming a superconducting joint between tapes having a core of an oxide superconductor precursor in a silver sheath comprises, removing a section of the sheath from the tapes to form an exposed core surface on each tape. The tapes are positioned to overlap the exposed core surfaces, and pressed to compact the cores and bond the sheaths to seal the compacted cores therebetween. The pressed tapes are heated to form the cores into a continuous oxide superconductor core.

A superconducting joint between tapes having a core of an oxide superconductor and a silver sheath is comprised of, a joint core comprised of the oxide superconductor and having a first width section extending between the tape cores to form a continuous superconducting path between the tapes. At least one pair of second width sections, each second width section extending from one of the tape cores and contiguous with the first width section to provide a continuous superconducting path from each tape core to the first width section. A silver sheath extending over the first and second width sections to seal the joint core therein and separate the second width sections.

As used herein, the term "oxide superconductor precursor", means an unsintered polycrystalline substantially phase pure material having the composition of an oxide superconductor, or a mixture of polycrystalline partially reacted material and oxides that can be reacted to form the substantially phase pure material.

The following description of the invention can be understood with greater clarity if reference is made to the following drawings.

### Brief Description of the Drawings

FIG. 1a is a top view of a superconducting tape showing the surface in the width and length dimension.

FIG. 1b is a top view of a superconducting tape showing an exposed core section of the tape.

FIG. 1c is a cross section of a side view of two tapes positioned so that the exposed core sections are overlapping.

FIG. 1d is a cross section of an end view of an oxide superconducting joint of this invention.

FIGS. 2a-b show another embodiment of the superconducting tapes in FIGS. 1a-b.

FIG. 2c is a cross section of an end view of an oxide superconducting joint of this invention.

### Detailed Description of the Invention

Several ceramic oxide systems are known to be superconducting. Of particular interest are the alkaline earth cuprate systems containing yttrium, bismuth, or thallium. The yttrium system contains oxides of about 1 gram atom of yttrium or a lanthanide, 2 gram atoms of barium, and 3 gram atoms of copper. The bismuth system contains oxides of about 2 gram atoms of bismuth, 2 gram atoms of strontium, 1 or 2 gram atoms of calcium, and 2 or 3 gram atoms of copper. The thallium system contains oxides of about 1 or 2 gram atoms of thallium, 2 gram atoms of barium which can be partially substituted with strontium, 1 or 2 gram atoms of calcium, and 2 or 3 gram atoms of copper.

A precursor powder of the oxide superconductor from the yttrium system, bismuth system, or thallium system can be formed by methods well known in the art. For example, the superconductors in the bismuth, thallium, or yttrium system can be prepared by solid state reaction of the oxides, or carbonates followed by sintering. Other methods, include coprecipitation from nitrate, acetate, or oxalate solutions and pyrolysis of metal organic precursors. Partial substitution of lead for bismuth in the bismuth system stabilizes the high temperature superconducting phases, and zero resistance above 100 K has been observed in a system with the composition Bi₂₋ₓPbₓSr₂Ca₂Cu₃O₁₀, where 0.2 ≦ x ≦ 0.6. The precursor powder can also be formed from a partly reacted powder of the desired superconductor. For example, a powder comprised of Bi₂Sr₂CaCu₂O_{8+y} mixed with suitable amounts of PbO, and a pre-reacted mixture of strontium calcium copper oxides can be used. The precursor powder is formed into a tape with a silver sheath, and the precursor can be heated to react the powder to form the oxide superconductor Bi₂₋ₓPbₓSr₂Ca₂Cu₃O_{10+y}, where 0.2 ≦ x ≦ 0.6.

Tape comprised of a core of an oxide superconductor precursor in a silver sheath can be formed by conventional methods known in the art, e.g., the powder in tube method. Briefly described, a silver tube formed from silver, or silver alloy that does not react with the oxide superconductor precursor to reduce the current carrying capacity of the oxide superconductor, is filled with the precursor powder of the oxide superconductor. The tube is sealed by caps bonded to the ends, and processed in a series of drawing, intermediate anneal, optional rolling, and annealing in an oxidizing atmosphere to reaction sinter the precursor powder and form a continuous oxide superconductor core in the elongated body. Additional information about processing in the powder in tube methods can be found in the disclosure of Matsumoto et al. cited above, or for example, in U.S. Patents 4,983,574, 4,952,554, and 4,980,964, incorporated herein by reference.

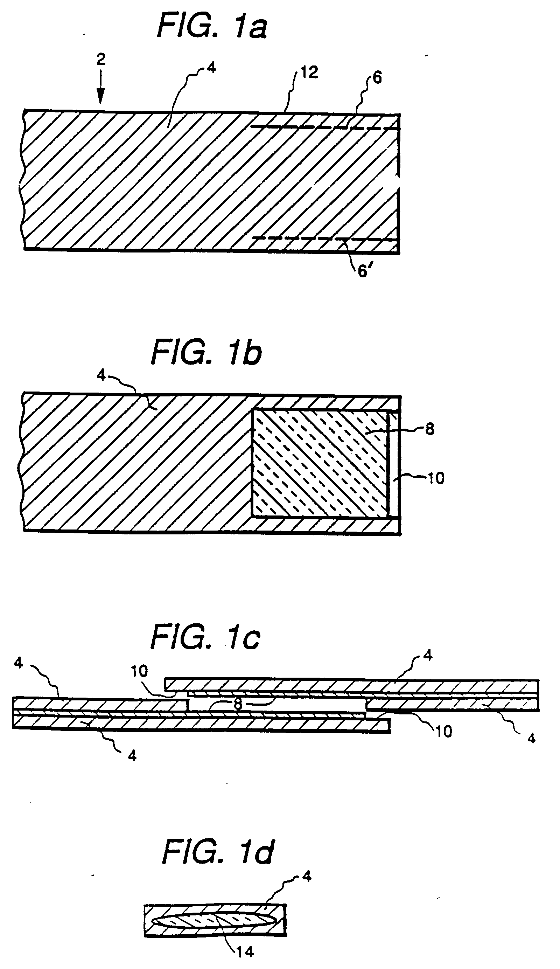

The method of forming, and the superconducting joint of this invention is shown by making reference to FIGS. 1a-d. Tape 2 has a core 8 of an oxide superconductor precursor enclosed in a silver sheath 4. Slits 6 and 6' are formed, for example with a razor or laser, in a line parallel to tape edge 12. The slits can be formed at about the distance from the edge where the core begins. Preferably, the slits are at least as long as the thickness of the tape core, but can be longer, for example as long as the width of the core. The section of silver sheath 4 between the slits 6 and 6' is peeled back from the core and removed from the tape by cutting with the razor or laser forming an exposed surface of core 8.

When tape 2 is formed by the powder in tube method, or other powder methods, the core 8 is a friable compact that can be damaged by the formation of slits 6 and 6', removal of the sheath section between the slits, or subsequent handling. Before forming slits 6 and 6' and removal of the sheath section therebetween, tape 2 can be heated to at least begin sintering the powder core. For example, a core formed with a powder of the bismuth system superconductor can be heated to about 830°C in air for about 50 hours to provide such sintering. The core is made more resistant to damage, e.g., crumbling and loss of powder from the exposed core surface, so that the tape has improved handling characteristics for the joint formation.

Optionally, a section of core 8 is removed at the tape end to form a tab 10 of the silver sheath 4 extending beyond core 8, and oppositely facing the exposed core surface. A second tape is formed in the same way, and the two tapes are positioned so that the exposed core surfaces are facing and overlap as shown in FIG. 1c. Tabs 10 of silver sheath 4 on each tape extend over the sheath on the other tape. The overlapping tapes are pressed to compact the facing core sections, and bond the silver sheaths together. For example, a suitable pressure is about 5 to 15 kilobars. The compacted core of the oxide superconductor precursor is sealed within the sheathing. The cores in the compact and tapes are heated in an oxidizing atmosphere to reaction sinter the oxide superconductor precursor forming the oxide superconductor core 14 , shown in FIG. 1d, and diffusion bond the silver sheathing 4. A strong superconducting joint can be formed having the current carrying capacity of the superconducting tape.

The pressed tapes are heated to reaction sinter the oxide superconductor precursor by annealing methods well known in the art to form a continuous core of oxide superconductor. For example, a precursor deposit of a yttrium system superconductor can be heated to about 900° to 1000°C, and bismuth or thallium system precursor deposits can be heated to about 800° to 900°C to reaction sinter the precursor deposit and form the respective superconductors. More specifically, it has been found that a bismuth system precursor can be heated at 830°C for about 200 hours in air to form the oxide superconductor. The tape is annealed in an oxidizing atmosphere to form the oxide superconductor.

A suitable oxidizing atmosphere for the bismuth system superconductors is comprised of at least about 3 volume percent oxygen and the balance an inert atmosphere such as nitrogen or argon. Preferably, oxygen is about 3 to 21 volume percent of the oxidizing atmosphere. It should be understood that air is a suitable atmosphere. Nitrogen can be a preferred remainder of the atmosphere since it can form nitrides with some of the solute metals that provide additional hardening of the silver. The oxide particles provide precipitation strengthening in the silver matrix and increase the strength and hardness of the sheathing.

Other superconducting systems can be reaction sintered in oxidizing atmospheres with different volume fractions of oxygen that are well known in the art. Additional information about annealing to form the oxide superconductors can be found, for example in, "Processing and Applications of High T_{c} Superconductors," W.E. Mao, Editor, The Metallurgical Society, PA, 1988, incorporated herein by reference.

The formation of the superconductor cores can be performed in a series of pressing and heating steps. For example, the pressed overlapping tapes can be heated to partially reaction sinter the oxide superconductor precursor, pressed to compact the partially sintered core, and heated to complete reaction sintering of the core. The intermediate pressing and partial sintering steps can be repeated two, three, or any desired number of times. It is believed that several intermediate pressing and heating steps provide a higher density core having a higher current carrying capacity. For example, a bismuth system precursor can be pressed at about 50 kilobars, heated to 830°C in air for 50 hours, and the pressing and heating steps repeated three times to form the reaction sintered oxide superconductor core.

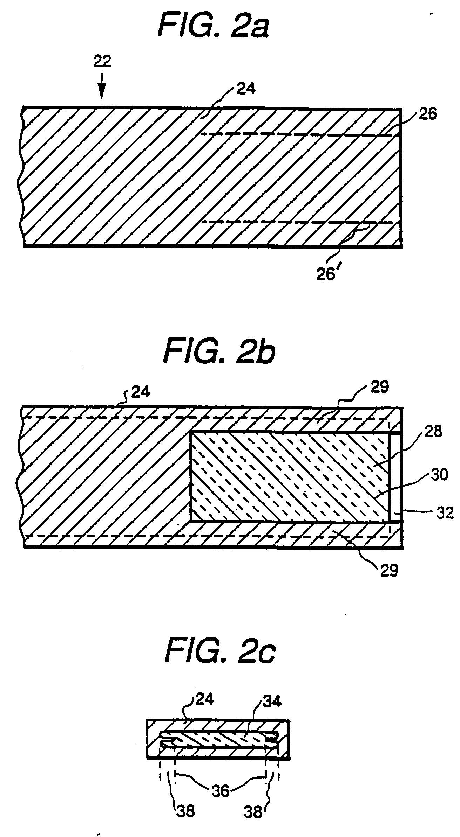

A preferred embodiment of the superconducting joint of this invention is shown by referring to FIGS. 2a-c. Tape 22 has a core of an oxide superconductor precursor 28 within a silver sheath 24. Slits 26 and 26' are formed parallel to the tape edge on one side of the silver sheath 24. The slits are formed a distance from the tape edge beyond where the core begins. For example, the slits can be formed at a distance from where the core begins of about 25 percent of the core width. As a result, a sheathed width section 29 of core 28 remains under sheath 24. The silver sheathing between the slits is peeled back from the core 28 and removed from the tape by cutting, forming exposed width section 30 of core 28. Preferably, a section of the core 28 is removed from the end of the tape to form tab 32.

Another tape is formed in the same way and the tapes are aligned in the width dimension so that the exposed width sections 30 and sheathed width sections 29 are overlapping, and tabs 32 extend over the sheathing of the other tape as had been shown in FIG. 1c. The overlapping tapes are pressed to compact the facing exposed width sections 30 of the cores 28 and form a pressure weld bond between the silver sheaths. The cores in the compact and tapes are heated in an oxidizing atmosphere to form the oxide superconductor precursor cores into an oxide superconductor core and diffusion bond the silver sheathing 24, the joint core 34 is shown in FIG. 2c. The reaction sintered superconducting joint core 34 is sealed in silver sheathing 24.

With this configuration, current can be transferred between tapes through a first width section 36 of joint core 34 that extends between the cores of the tapes being joined forming a continuous superconducting path between the tapes. Current can also be transferred from the tape into or out of the joint along the entire length of the joint due to second width sections 38 that extend from the oxide superconducting cores of each tape and are contiguous with the first width section 36. As a result, all current flow through the tapes does not have to transfer into the joint at the transition between the tape and joint, i.e. where the joint begins and ends. The transition can contain damage caused by the pressing, and not healed in the heating to reaction sinter the compacted cores, and as a result may have a reduced current carrying capacity as compared to the core in the tape or overlap section of the joint.

Additional features and advantages of the oxide superconductor joint, and method of this invention are shown in the following Examples.

### Example I

A tape was formed with a silver sheath surrounding a core of bismuth-strontium-calcium-copper oxide by the conventional powder in tube process. Briefly described, powder with the overall composition Bi_{1.7}Pb_{0.3}Sr₂Ca_{2.75}Cu_{3.75}O_{y} was poured into a silver tube having an outside diameter of 6.34 millimeters, and a wall thickness of about 1 millimeter. The tubes were sealed at both ends with silver plugs by swaging. The filled and sealed tube was swaged to a diameter of 4.21 millimeters, with 12 percent reductions in cross-section per pass. The swayed tube was drawn through a series of drawing dies to reduce the diameter to 1.52 millimeters, and form a wire. The drawing was performed with reductions of about 12 percent per pass. The drawn wire was rolled and flattened by repeated passing between spaced rolls. The roll spacing was reduced about 12 to 15 percent per pass to form a final tape having a width of about 3 millimeters, and a thickness of about 0.25 millimeter

Tape samples about 10 centimeters long were cut from the rolled tape. At one end of each tape sample the silver sheath on one surface was slit with a razor on a line parallel with the tape edge about one-half millimeter from each edge of the tape, about where the core begins, to form slits extending about 4 to 5 centimeters from the tape end. The section of silver sheathing between slits was slowly peeled back exposing the superconducting core. The peeled back section was removed from the tape by cutting with the razor. At the tape end, about 5 millimeters of the core section was removed to form a tab of the silver sheathing on the surface opposite the exposed core surface. A second tape was prepared in the same manner, and the two tapes were positioned so that the exposed cores were facing and overlap, and the sheath tabs extended over the sheath of the other tape as shown in FIG. 1c.

The overlapping tapes were pressed between hardened steel dies about 15 by 10 centimeters, at about 5 kilobars to cold weld the silver sheathing and compact the exposed core sections. The pressed tapes were heated in air to about 830°C for 50 hours. The same pressing and heating conditions were repeated 3 times to reaction sinter the cores, form the oxide superconductor; diffusion bond the silver sheathing, and form the superconducting joint.

The joint was tested to determine the current-carrying capability of the Joint using the four probe resistance measurement technique well known in the art. A first and second voltage probes were soldered about 10 millimeters apart onto the superconducting joint, a third and fourth voltage probes were soldered to the superconducting tape at a distance before the joint of about 20 and 30 millimeters, and a fifth voltage probe was soldered to the superconducting tape at a distance of about 10 millimeters after the joint. Current leads were soldered onto the superconducting tape at a further distance from the voltage probes on each side of the joint. With this configuration the current carrying capacity could be measured for; the overlapping joined tapes between probes 1 and 2, the transition before the joint between probes 4 and 1, the tape between probes 3 and 4, and the transition after the joint between probes 2 and 5.

The joint was cooled to 77 K by cooling in liquid nitrogen. A current was passed through the joint in increasing steps, and the voltage was recorded from the probes on each side of the joint. In this test, the critical current was defined as the current which caused a voltage differential of 0.5 microvolts between the probes. A Section of superconducting tape that did not contain a joint was similarly tested to determine the critical current of the tape. The critical currents measured on the tape sample and joint are shown below in Table I.

**Table I**

| Critical Current Measured at 77K | | |
|---|---|---|
| Probes | Location | Critical Current (Amps) |
| 3-4 | Tape | 7.3 |
| 4-1 | Transition | 5.5 |
| 2-5 | Transition | 7.8 |
| 1-2 | Overlap | 14.1 |

### Example II

Two more tape samples from the tape formed in Example I were first heated to 830°C for 50 hours in air. The once heated tape samples were processed into a superconducting joint as described in Example I, tested using the four probe resistance measurement technique, and the critical currents measured in the tape and joint are shown below in Table II.

**Table II**

| Critical Current Measured at 77 K | | |
|---|---|---|
| Probes | Location | Critical Current (Amps) |
| 3-4 | Tape | 6.6 |
| 4-1 | Transition | 5.6 |
| 2-5 | Transition | 6.05 |
| 1-2 | Overlap | 14.5 |

Referring to Tables I and II, it is shown that the current carrying capacity in the overlap section of the superconducting joint is about twice the current carrying capacity of the superconducting tape. However, the current carrying capacity at the transitions between the joint and the tape varies from slightly below to comparable to the current carrying capacity of the tape. The variable current carrying capacity at the transitions is believed to be from insufficient healing of damage caused by pressing in forming the joint. Since the joint itself contains about twice the volume of oxide superconductor as compared to the tape, the overlap section of the joint exhibits current carrying capacity about twice the tape. In the preferred joint of this invention, current can transfer through the joint all along the length of the joint through the sheathed width section of the core so that damage at the transition portions of the joint does not limit current transfer through the joint.

## Claims

1. A method for forming a superconducting joint between tapes having a core of an oxide superconductor precursor in a silver sheath, the method comprising,
removing a section of the sheath from the tapes to form an exposed core surface on each tape,
positioning the tapes to overlap the exposed core surfaces,
pressing the overlapping tapes to compact the cores, and bonding the sheath to seal the compacted cores therebetween, and
heating the pressed tapes to form the cores into a continuous oxide superconductor core.

2. A method for forming a superconducting joint according to claim 1 wherein the oxide superconductor precursor is a powder comprising, before the step of removing, heating the tapes to at least begin sintering of the powder.

3. A method for forming a superconducting joint according to claim 1 or 2 comprising, after the step of heating, pressing the tapes to compact the oxide superconductor core and reheating the compacted tape to form a continuous oxide superconductor core.

4. A method for forming a superconducting joint according to claim 1 wherein the oxide superconductor is a bismuth system oxide superconductor.

5. A method for forming a superconducting joint between tapes having a core of an oxide superconductor precursor in a silver sheath, the tape having oppositely facing major surfaces in the width and length dimension, the method comprising,
removing from one tape surface a section of the sheath so that the core has an exposed width section and a sheathed width section,
positioning the tapes so the exposed and sheathed width sections are facing and overlap,
pressing the overlapping tapes to compact the exposed width sections, and bonding the sheaths to seal the compacted cores therebetween, and
heating the pressed tapes to form the cores into a continuous oxide superconductor core.

6. A method for forming a superconducting joint according to claim 5 wherein the oxide superconductor precursor is a powder comprising, before the step of removing, heating the tapes to at least begin sintering of the powder.

7. A method for forming a superconducting joint according to claim 5 or 6 comprising, after the step of heating, pressing the tapes to compact the oxide superconductor core, and reheating the compacted tapes to reform the continuous oxide superconductor core.

8. A method for forming a superconducting joint according to claim 5 wherein the oxide superconductor is a bismuth system oxide superconductor.

9. A method for forming a superconducting joint according to claim 5 comprising, before the step of pressing, removing a section of the core at the tape end so that a sheath tab extends beyond the core.

10. A superconducting joint between tapes having a core of an oxide superconductor and a silver sheath comprising,
a joint core comprised of the oxide superconductor and having a first width section extending between the tape cores to form a continuous superconducting path between the tapes, and at least one pair of second width sections each second width section extending from one of the tape cores and contiguous with the first width section to provide a continuous superconducting path from each tape core to the first width section, and a silver sheath extending over the first and second width sections to seal the joint core therein and separate the second width sections.
